# EUROPEAN PATENT SPECIFICATION

(11) **EP 1 452 624 B1**
(45) Date of publication and mention of the grant of the patent: **11.06.2008**
(21) Application number: 03024294.5
(22) Date of filing: 23.10.2003
(51) Int. Cl.: C23C 16/04, C23C 16/458, C23C 16/46, C23C 16/54

(54) **Process and apparatus for batch and continuous densification by chemical vapor infiltration (CVI)**
Verfahren und Vorrichtung zur stückweisen und zur kontinuierlichen Verdichtung durch chemische Dampfphaseninfitration (CVI)
Procédé et dispositif de densification continu et discontinu par infiltration chimique en phase vapeur (CVI)

(30) Priority: 24.10.2002 US 421393 P
(43) Date of publication of application: 01.09.2004
(73) Proprietor: Goodrich Corporation, Charlotte, North Carolina 28217 (US)
(72) Inventor: Bok, Lowell D., Anna Ohio 45302 (US); Purdy, Mark, Akron Ohio 44333 (US); Clark, Gary, Maplewood Ohio 45340 (US); Bazshushtari, Afshin, Rolling Hills Estates California 90274 (US)
(74) Representative: Hilleringmann, Jochen

(56) References cited:
- EP-A- 0 846 787
- EP-A- 0 995 815
- EP-A- 1 285 976
- WO-A-96/15285
- US-A- 5 348 774
- US-A- 5 480 678
- US-A- 5 904 957
- US-B1- 6 572 371
- PATENT ABSTRACTS OF JAPAN vol. 015, no. 219 (E-1074), 5 June 1991 (1991-06-05) & JP 03 062515 A (MATSUSHITA ELECTRIC IND CO LTD), 18 March 1991 (1991-03-18)

## Description

### BACKGROUND OF THE INVENTION

Chemical vapor infiltration and deposition is a well known process for depositing a binding matrix within an openly porous structure. The term chemical vapor deposition, "CVD" generally implies only the deposition of a surface coating. However, the term has also been used to describe not only the deposition but also the infiltration of a matrix within a porous structure. Therefore, for purposes of this application, the term chemical vapor infiltration, "CVI" is intended to refer to not only the infiltration but also the deposition of a binding matrix within a porous structure. This technique is particularly suitable for fabricating high temperature structural composites by depositing a carbonaceous or ceramic matrix within a carbonaceous or ceramic porous structure resulting in structures such as carbon/carbon aircraft brake disks, and ceramic combustor or turbine components.

In general, in the CVI process for carbon deposition, an openly porous material or structure is exposed to a gas under conditions that decompose or crack the gas into carbon very slowly. The carbon is deposited into porous structure or material to form a composite material comprising the porous structure with a matrix filler within the porous structure. In conventional CVI processes, the outside of the porous structure densifies more quickly than the interior of the structure. This densification decreases the porosity of the surface and prohibits the hydrocarbon gas from uniformly depositing on and in the porous structure. Therefore, the process must be interrupted and the porosity restored by machining the porous structure to remove the occluded surface.

The generally known CVI processes may be classified into four general categories: isothermal, thermal gradient, pressure gradient, and pulsed flow. *See* W.V. Kotlensky, Deposition of Pyrolytic Carbon in Porous Solids, 8 Chemistry and Physics of Carbon, 173, 190-203 (1973); W.J. Lackey, Review, Status, and Future of the Chemical Vapor Infiltration Process for Fabrication of Fiber-Reinforced Ceramic Composites, Ceram. Eng. Sci. Proc. 10[7-8] 577, 577-81 (1989). In an isothermal CVI process, a reactant gas passes around a heated porous structure at absolute pressures as low as a few torr. The gas diffuses into the porous structure driven by concentration gradients and cracks to deposit a binding matrix. This process is also known as "conventional" CVI. Although the process is coined "isothermal" due to the fact that the porous structure is heated to a more or less uniform temperature, this is actually a misnomer. Some variations in temperature within the porous structure are inevitable due to uneven heating (essentially unavoidable in most furnaces), cooling of some portions due to reactant gas flow, and heating or cooling of other portions due to heat of reaction effects. Hence, "isothermal" means that there is no attempt to induce a thermal gradient that preferentially affects deposition of a binding matrix onto the porous structure. This process is well suited for simultaneously densifying large quantities of porous articles and is particularly suited for making carbon/carbon brake disks. With appropriate processing conditions, a matrix with desirable physical properties can be deposited. However, the conventional CVI process is a very slow process and may require weeks of continual processing in order to achieve a useful density. Moreover, the surface tends to densify first resulting in "seal-coating" that prevents further infiltration of reactant gas into inner regions of the porous structure and uniform deposition of the matrix material within the porous structure. Thus, this technique generally requires several surface machining operations that interrupt the densification process

In a thermal gradient CVI process, a porous structure is heated so that a steep thermal gradient is generated which induces deposition in a desired portion of the porous structure. The thermal gradients may be induced by heating only one surface of a porous structure. For example, the thermal gradient may be generated by placing a porous structure surface against a susceptor wall in an electric induction heated furnace. The gradient created may be further enhanced by cooling an opposing surface, for example by placing the opposing surface of the porous structure against a liquid cooled wall. Deposition of the binding matrix progresses from the hot surface to the cold surface. The equipment for use in a thermal gradient process tends to be complex, expensive, and difficult to implement for densifying relatively large quantities of porous structures.

In a pressure gradient CVI process, the reactant gas is forced to flow through the porous structure by inducing a pressure gradient from one surface of the porous structure to an opposing surface of the porous structure. The flow rate of the reactant gas is greatly increased relative to the isothermal and thermal gradient processes which results in increased deposition rate of the binding matrix. This process is also known as "forced-flow" CVI/CVD. The equipment for pressure gradient CVI/CVD can be complex, expensive, and difficult to implement for densifying large quantities of porous structures. An example of a process that generates a longitudinal pressure gradient along the lengths of a bundle of unidirectional fibers is provided in S. Kamura, N. Takase, S. Kasuya, and E. Yasuda, Fracture Behaviour of C Fiber/ CVD C Composite, Carbon '80 (German Ceramic Society) (1980). An example of a process that develops a pure radial pressure gradient for densifying an annular porous wall is provided in United States Patents Nos. 4,212,906 and 4,134,360. The annular porous wall disclosed by these patents may be formed from a multitude of stacked annular disks (for making brake disks) or as a unitary tubular structure. For thick-walled structural composites, a pure radial pressure gradient process generates a very large, undesirable density gradient from the inside cylindrical surface to the outside cylindrical surface of the annular porous wall.

Other examples of a pressure gradient process and equipment used in the process can be found in U.S.-A-5,480,678 and US-A-5,853,485. In particular, U.S.-A-5,853,485 discloses a pressure gradient process for forcing the infiltration of a reactant gas into a porous structure.

Finally, pulsed flow involves cyclically filling and evacuating a chamber containing the heated porous structure with the reactant gas. The cyclical action forces the reactant gas to infiltrate the porous structure and also forces removal of the cracked reactant gas by-products from the porous structure. The equipment to implement such a process is complex, expensive, and difficult to maintain. This process is very difficult to implement for densifying large numbers of porous structures.

The thermal gradient and pressure gradient processes have been combined by many workers resulting in a "thermal gradient-forced flow" process. Combining the processes appears to overcome some of the shortcomings of each of the individual processes and results in very rapid densification of porous structures. However, combining the processes also results in twice the complexity since fixturing and equipment must be provided to induce both thermal and pressure gradients with some degree of control. A process for densifying small disks and tubes according to a thermal gradient-forced flow process is disclosed by United States Patent 4,580,524; and by A.J. Caputo and W.J. Lackey, Fabrication of Fiber-Reinforced Ceramic Composites by Chemical Vapor Infiltration, Prepared by the OAK RIDGE NATIONAL LABORATORY for the U.S. DEPARTMENT OF ENERGY under Contract No. DE-AD05-840R21400 (1984). According to this process, a fibrous preform is disposed within a water cooled jacket. The top of the preform is heated and a gas is forced to flow through the preform to the heated portion where it cracks and deposits a matrix. A process for depositing a matrix within a tubular porous structure is disclosed by United States Patent No. 4,895,108. According to this process, the outer cylindrical surface of the tubular porous structure is heated and the inner cylindrical surface is cooled by a water jacket. The reactant gas is introduced to the inner cylindrical surface. Similar forced flow-thermal gradient processes for forming various articles are disclosed by T. Hunh, C.V. Burkland, and B. Bustamante, Densification of a Thick Disk Preform with Silicon Carbide Matrix by a CVI Process, Ceram. Eng. Sci. Proc 12[9-10] pp. 2005-2014 (1991); T.M. Besmann, R.A. Lowden, D.P. Stinton, and T.L. Starr, A Method for Rapid Chemical Vapor Infiltration of Ceramic Composites, Journal De Physique, Colloque C5, supplement au n°5, Tome 50 (1989); T.D. Gulden, J.L. Kaae, and K.P. Norton, Forced-Flow Thermal-Gradient Chemical Vapor Infiltration (CVI) of Ceramic Matrix Composites, Proc.-Electrochemical Society (1990), 90-12 (Proc. Int. Conf. Chem. Vap. Deposition, 11th, 1990) 546-52.

These CVI processes can be used to infiltrate and deposit a binding carbon matrix within a porous material. U.S.-A-4,291,794 describes the formation of carbon and graphite composite materials for use as friction facing materials. The composite materials result from the densification of a thin carbon cloth substrate using chemical vapor deposition techniques. During densification, the substrates may be stacked one upon another, suspended within the furnace on rods or hung from clips. After densification, the substrate can be heat treated or chemically treated depending upon the particular end product use. U.S.-A-6,132,877 discloses the use of a single layer of woven carbon fabric mesh which is progressively infiltrated by chemical vapor deposition of natural gas to a high density. The resultant composite material is rigid and has little porosity.

US-A-5,348,774 discloses a method and apparatus for the rapid densification of porous structures by means of chemical vapor densification. The known method can be applied to a furnace and includes the introduction of the reactant gas such a methane into a CVI chamber wherein insulating heat shields are positioned above and below the porous products to reflect heat.

US 5,904,957 also discloses a method and apparatus for the densification of porous structures by CVI and in particular suggests a means of improving the gas circulation within the furnace in order to solve the problem of non-uniform densification of the porous bodies.

JP-A-03 462515 and the corresponding patent abstracts of Japan Vol. 015, no 219 (E-1074), June 5, 1991 discloses a similar process in which heater plates are used in a furnace to provide uniform heating of a material processed in a vacuum chamber.

In spite of all of these advances, there still is a need to uniformly disperse the reactant gas on a porous structure or material, to tailor the densification rate of the structure or material as well as to minimize the density gradient on such structure or material in either a batch or continuous CVI process.

### BRIEF SUMMARY OF THE INVENTION

The present invenetion provides a module and process for processing porous material in a CVI furnace as specified in claim 1 and 7, respectively. The dependent claims relate to individual embodiments of the invention.

A CVI furnace is disclosed in which a module containing porous material is loaded into a CVI furnace. The CVI furnace can be comprised of several chambers, including but not limited to a CVI chamber. If a module is loaded into a furnace, it can be loaded singularly or as multiple units stacked vertically or side by side and then the module is advanced through different chambers of the furnace, either step-wise or continuously. In one embodiment of the invention, the furnace can be loaded or unloaded without lowering the temperature of the CVI chamber and thereby maintaining the temperature in the CVI chamber uniform. Keeping the temperature uniform in the CVI chamber of the furnace of this embodiment reduces the total densification cycle time.

Furthermore, in this CVI furnace, the porous material is heated uniformly by heater plates located proximately to the porous material of the module. The reactant gas is introduced into the CVI chamber and the process conditions, including the temperature of the CVI chamber and the flow of gas into the chamber, are maintained in each region or zone substantially uniform, whereas each zone or region of the CVI furnace may have different controlled process conditions, whereby the porous material is densified. With this arrangement, the density gradient in the porous material is minimized.

A module configuration is used in the CVI furnace to hold layers of porous material to be densified in the furnace. With the use of the module configuration, several sheets of porous material can be stacked and densified to a desired density in a furnace.

Although the details set forth herein are directed to a process and equipment for carbon densification, it should be understood that the process and equipment can be used to deposit a ceramic upon a porous material.

### BRIEF DESCRIPTION OF SEVERAL VIEWS OF THE DRAWINGS

FIG. 1 illustrates a schematic view of a furnace and apparatus according to an aspect of the invention.
FIG. 2 illustrates a schematic view a furnace according to another aspect of the invention.
FIG. 3 illustrates a schematic view of a furnace according to yet another embodiment of the invention.
FIG. 4 illustrates a schematic view of a furnace showing the multiple layers of carbon cloth stacked into modules and the process of moving the modules through a furnace shown in FIG. 3.
FIG. 5 illustrates a schematic view of a furnace according to yet another embodiment of the invention.
FIG. 6 shows a cross-sectional view of a conventional furnace modified according to yet another embodiment of the invention.
FIG. 7 shows a schematic view of yet another embodiment of the modules in a furnace according to this invention.
FIG. 8 illustrates a detailed view of a stack of modules that can be used in the furnace of the invention.
FIG. 9 illustrates a detailed view of yet another embodiment of a stack of modules that can be used in the furnace of the invention.
FIG. 10 illustrates a detailed view of yet another embodiment of a module that can be used in the furnace of the invention.
FIG. 11 illustrates a detailed view of yet another embodiment of a porous material and screen that can be placed in module that can be used in the furnace of the invention.
FIG. 12a, 12b, 12c illustrate a detailed view of a screen and porous material which can be used in a module in conjunction with the furnace of the invention.
FIG. 13 illustrates a schematic view of the furnace according to yet another embodiment of the invention.

### DETAILED DESCRIPTION OF THE INVENTION

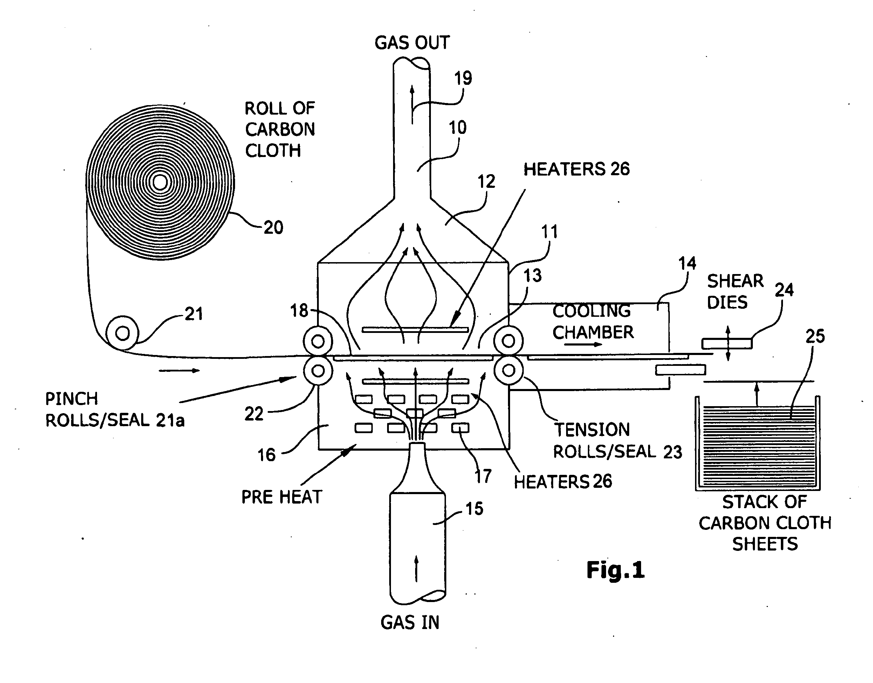

Various aspects of the invention are presented in FIGS. 1-13, which are not drawn to scale, and wherein like components, are numbered alike. Referring now to FIGS. 1-13, representations of the basic concepts according to certain aspects of the invention are now presented. Literal interpretation of the configurations presented in FIGS. 1-13 is not intended to limit the invention to the specific arrangements presented, as other variations or modifications are possible that are evident to persons skilled in the art in light of the description provided herein.

Although the FIGURES and details set forth below are directed to carbon densification, the process described herein can be used to form a high temperature structural composite by either the deposition of a ceramic or carbonaceous material matrix within a carbonaceous or ceramic porous material. Consequently, the equipment used in such process as well as the process itself may differ depending upon the type of matrix material used as well as the type of porous material which the matrix is being deposited on.

FIG. 1 shows a schematic depiction of a CVI furnace which can densify a porous material. The furnace (10) has a furnace shell (11) that defines an inner volume (12). The inner volume can be divided into separate chambers. The furnace can include a CVI chamber (13) and a cool down chamber (14) as illustrated in FIG. 1. The furnace receives a reactant gas from a gas inlet (15) as indicated by the arrow. The gas inlet (15) receives the reactant gas from a gas supply line. The flow rates of the reactant gas depend upon the desired end result of the porous material as well as furnace size and other furnace conditions. The reactant gas is optionally preheated by a pre-heater (16) that is disposed within the furnace. The pre-heater design can be any design desired to achieve the results. Preferably, the pre-heater and used in this CVI furnace is the one described in U.S.-A-5,480,678.

The CVI chamber of the CVI furnace may be heated by induction heating, resistance heating, microwave heating, or any other heating method. For example, the CVI chamber is heated by resistance heating. Preferably the resistance heater is made of a heater plate (26) as illustrated in FIG.1. A preferred heater plate is made from graphite. The heater plates can be located proximate to the porous material. The heater plates can be located both above and below the porous material.

In another example, the CVI chamber is heated by induction heating, which comprises a susceptor disposed within the furnace. The susceptor preferably includes a susceptor wall and a floor with induction coils. An insulation barrier is disposed between the susceptor wall and induction coils. An alternating current through the induction coils generates an alternating electrical field that induces an electrical current in the susceptor which is then resistively heated due to the induced electrical current.

The porous material to be densified by the process is disposed within this CVI chamber and is predominantly heated by radiant heat in the example of FIG. 1. The CVI chamber is maintained at substantially uniform process conditions. That is, the gas flow (both rate of flow and direction) and the temperature along the length and width of the CVI chamber can be adjusted to maintain uniformity. The CVI chamber may be maintained at a temperature ranging from about 930°C (1700° F) to about 1.370°C (2500°F) depending on the preferred reaction rate to get the desired microstructure, uniformity, density and cycle times for the densification of carbon. The face of the porous material is heated by the radiant heaters to achieve a uniform temperature across the face of the porous material. However, the temperature could be varied from one end of the porous material to the other end, to modulate the densification rates depending upon the composite density. The desired furnace temperatures are held constant throughout the process and hence reduces the total densification cycle time and eliminates the time needed to heat up and cool down conventional furnaces.

The CVI chamber is generally maintained at a temperature in the range of about 930°C (1700°F) to about 1.370°C (2500° F), most preferably 1.150°C (2100° F) for densification of carbon. The pressure in the CVI chamber is in the range of about 10 torr to atmospheric pressure; preferably in the range of 50 to about 200 torr. Most preferably, the pressure in CVI chamber is 50 torr. The temperature and pressure conditions are chosen to cause the reactant gas to crack and deposit a carbon matrix having certain desired properties within the porous material.

FIG. 1 includes a pre-heater (16) in the CVI chamber (13). A pre-heater is optional in the furnace of this invention. A preferred pre-heater for use in any of the CVI furnaces of the invention is described in U.S.-A-5.480,678. The pre-heater (16) receives reactant gas from a gas inlet (15) and raises the reactant gas temperature at the exit of the pre-heater to approximately the temperature of the CVI chamber. The pre-heater (16) can be made of a baffled structure (17) within the furnace, which comprises an array of rods, tubes, perforated plates or equivalent structure for dispersing the flow and increasing convective heat transfer from the baffle structure to the reactant gas. The various components of the pre-heater are preferably formed of monolithic graphite.

After being preheated, the reactant gas enters the CVI chamber (13) and passes around and through the porous material (18). The gas flow rate is dependent upon furnace configuration and can be varied as desired in the CVI chamber (13). Preferably, a gas flow rate in the range of about 5 to about 100 standard cubic centimeters per minute ("sccm") of gas per square centimeter of fabric processed is used; most preferably, 10 to about 40 sccm of gas per square centimeter.

Any type of reactant gas can be used provided that the reactant gas can deposit a binding matrix onto the porous material. The reactant gas can be a mixture of gases. Preferably the mixture can be natural gas. Propane and ethane can be added to the natural gas. Preferably the mixture can be a mixture of natural gas and propane, with up to 40% (volume %) of the mixture being propane. An example of a reactant gas which can be used comprises 87% natural gas and 13% propane (volume %). Most preferably, the reactant gas comprises 92.5% natural gas and 7.5% propane (volume %). A representative natural gas which can be used may have a composition of 94.6% methane (volume %), 1.80% ethane, 0.5% propane, 0.15% butane, 0.05% pentane, 0.70% carbon dioxide and 0.40% nitrogen.

The reactant gas infiltrates the porous material (18) and deposits a binding matrix on the porous material. The reactant gas leaves the CVI chamber (13) through the exhaust (19) as indicated by the arrow.

The porous material (18) used in the furnace can be obtained from a roll of material (20) as illustrated in of FIG. 1. The roll can be any roll of porous material that is wrapped around a mandrel. In this example the porous material is continuously fed into the furnace (10) by a guide roller (21). However, any type of conveyor can be used including bar flight, belt, oscillating or vibrating, and rotary can be used, provided that the components of the conveyor can withstand the temperature in the furnace.

Prior to entering the CVI chamber (13), the porous material (18) is pinched with pinch rollers (21a) or any other type of device which can straighten, tension and smooth out the porous material. In FIG. 1, seals (22) are also provided by the pinch rollers at the entrance of the CVI chamber, in order to provide a sealed CVI chamber. The porous material is maintained taut while in the CVI chamber by tension rollers (23) having seals as illustrated in FIG. 1. The sealed CVI chamber also provides means to achieve various pressures from atmospheric to vacuum to get a combination of temperatures and pressures to meet the densification objectives depending on the material requirements. These temperatures and pressures can easily be determined by one of ordinary skill in the art.

After passing through the CVI chamber, the reactant gas is deposited onto the porous material at a predetermined rate to achieve the desired density. The desired density can be monitored by the use of a feedback mechanism which measures the density of the porous material and then adjusts the furnace parameters (gas flow rate, temperature, pressure) to achieve the desired density. Alternatively, the sample can be weighed at the end of the process, the weight measurement is then converted to density and the furnace parameters are adjusted. This process can be either automatic or manual.

The porous material (18) then passes through a cooling chamber (14) that is part of the furnace but independent of the CVI chamber, to cool the porous material to a temperature below the safe temperature to prevent oxidation when exposed to air. Preferably, the densified material is cooled below about 482°C (900° F) in order to prevent significant oxidation of the densified material when exposed to air. If the porous material is ceramic, the densified material is cooled down to less than about 815°C (1500 ° F) to prevent significant oxidation. After passing through the cooling chamber, as shown in FIG. 1, the densified porous material may then be cut by shear dies (24) and stacked into sheets (25).

The porous material to be densified by the furnace of this invention can be any porous material including materials made from fibers, including but not limited to carbon, graphite, carbonized wool, rayon, polyacrylonitrile or ceramic fibers. The fibers can be stretch broken or continuous. Furthermore, the fibers can be needled or formed into a fabric or a preform. The porous material is selected depending upon the end application of the material. For example, carbon fabric will be commonly used for automotive wet friction applications, whereas ceramic fabric is more desirable for high temperature, friction and structural applications. An example of a porous material which can be used in the furnace is SW08, a polyacrylonitrile based carbon fiber that is woven in an eight harness satin weave, supplied by Zoltek Companies, of 3101 McKelvey Rd., St. Louis, Missouri 63044. When densified in the furnace, SW08 may form a composite having a bulk composite density in the range of about 0.8 to about 1.6 grams per cubic centimeter (g/cc).

Alternatively, multiple layers of the porous material can be feed into a CVI chamber of FIG. 1, by using multiple rolls of the porous materials or by double rolling the porous material onto one single roll (not shown). A scrim material may be used to provide support and tensioning of the porous material as it is feed into the CVI chamber. The scrim material is substantially burned off during the CVI process. An example of a scrim material that can be used in this invention is a cotton scrim material.

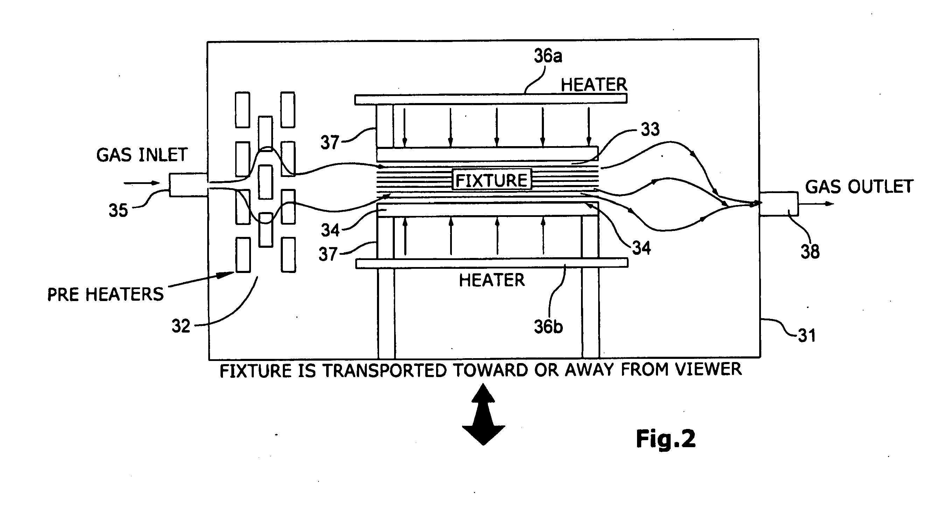

Referring now to FIG. 2, a CVI chamber (31) of an embodiment of the furnace is illustrated. The process conditions of the CVI chamber (31) of this embodiment are the same as those described above with respect to the embodiment of FIG. 1.

However, in the embodiment of FIG.2 as compared to the embodiment of FIG.1, the pre-heater (32) is part of the CVI chamber and numerous layers of porous material (33) are stacked into a module or fixture (34). Any type of module or fixture which can hold numerous layers of porous materials taut or flat and withstand the temperature conditions of the CVI chamber can be used, including those modules described later herein.

The modules (34) are loaded into each chamber of the furnace step-wise or continuously, including the CVI chamber, and advance into each chamber of the furnace by means of a conveyor. Alternatively, any other means can be used to move the module into the CVI chamber as well as through the furnace including for example a pusher-ram, or a piston/cylinder. Preferably, the modules are loaded continuously into each chamber of the furnace.

As shown in FIG. 2, the module (34) or fixture carrying the porous material is then moved into the CVI chamber (31) and maintained in the CVI chamber until the desired density on the porous material is achieved. Preferably, the porous material forms a composite having a bulk composite density in the range of about 0.8 to about 1.7 grams per cubic centimeter (g/cc) and will vary depending upon the application of the composite.

For example, if a single sheet of material is being densified, it may be maintained in the CVI chamber for approximately ten hours. Processing multiple sheets or modules can improve the processing throughput without a significant impact on the overall cycle time needed to obtain the desired density because of the uniform gas flow, composition and rate that can be achieved across each layer of sheet in the module as well as the various modules, themselves. The number of layers in a module is limited by the temperature drop across the layers and/or stacks which impacts the density of the porous layers themselves.

Reactant gas is then introduced to the CVI chamber at a gas inlet (35). The reactant gas is heated in the pre-heater (32). The pre-heater (32) can be a baffled structure. A heater plate is disposed above (36a) and below (36b) the module (34) in the CVI chamber (31) in this embodiment. Any type of heater can be used. Preferably, the heater plate is a resistance heater. Most preferably, the resistance heater is a graphite resistance heater. The heater plate can be placed above and below the area in which the module is placed to ensure that the porous material stacked in the module is heated as illustrated. Heat is applied above and below the module (34) to assure uniform temperature distribution across the face of the porous material. Preferably, the heater will be maintained the range of about 982°C (1800°F) to about 1.065°C (1950°F); most preferably 1.015°C (1860 °F). However, the temperature may vary across the length of the module to achieve the desired density in the porous material. Alternatively, there may be only one heater plate located proximately to the porous material.

The reactant gas is then funneled from the pre-heater (32) towards the module (34). Seals (37) are included between the pre-heater (32) and the module (34). Any type of seal can be used provided that the seal enables the incoming gas to flow through the stack of material rather than by-passing it. These seals are formed from a graphite, although carbon felt or ceramic based seals can also be used. Seals are included on the inlet side to prevent gas by-pass around the module. The reactant gas flows through the module (34) and across and around the porous material (33) stacked in the module. The reactant gas then leaves the CVI chamber (31) through the gas outlet (38) in this embodiment. After a period of time sufficient to densify the porous material in the module, the module (34) is then removed from the CVI chamber (31). Generally, the desired densification of the porous material can occur in the range of about 5 to about 250 hours, depending upon the density targets and composite targets. The amount of time needed to densify the material in the furnace to its desired density can be calculated or determined empirically by one of ordinary skill in the art in view of the actual conditions used in the furnace.

Optionally, the porous material in the module is then subject to additional heat treatment, chemical treatment or high temperature inert atmosphere heat treatment. This optional heat treatment can be used in any embodiment of the invention described herein. For example, chemical treatment can include treatment with a suitable oxidation inhibitor to prevent further oxidation. Another module is then moved into the CVI chamber and the process is repeated. Although not shown, an optional pre-treatment step, with heat or a coating may be carried out prior to densification if desired.

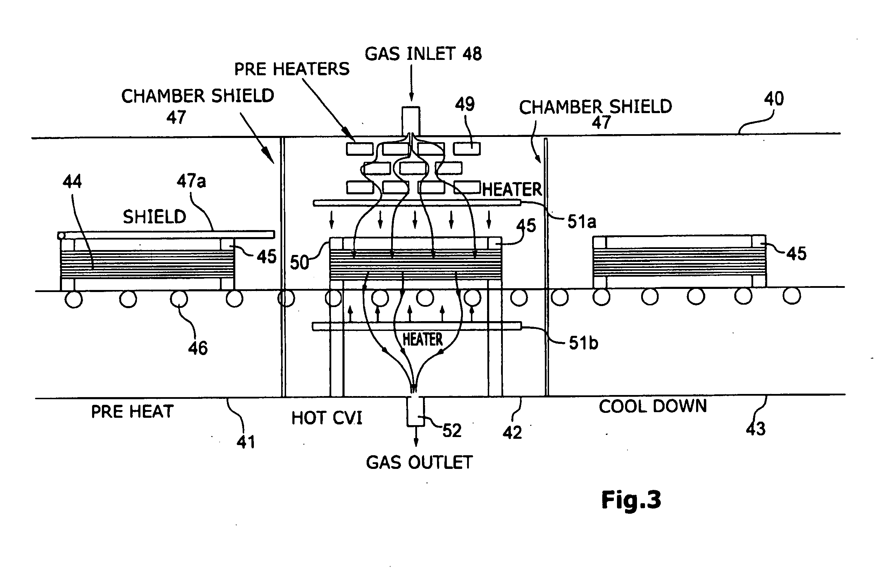

FIG. 3 illustrates yet another embodiment of the CVI furnace (40). The CVI furnace (40) is maintained at the process conditions described above with respect to the example of FIG.1. In this embodiment, the CVI furnace includes a preheat chamber (41), a CVI chamber (42) and a cool-down chamber (43). Porous material (44) stacked into a module (45) is moved into the preheat chamber (41). In this embodiment, a sliding conveyor (46) is used. Alternatively, any type of conveyor or pusher can be used to move the modules into the furnace. Optionally, although not necessary in this embodiment, a shield (47a) that will prevent the reactant gases from flowing into the pre-heat chamber (41) can be placed above the module (45). The preheat chamber (41) is heated to temperatures approximately equal to the temperature in the CVI chamber (42) to minimize the temperature drop as the module is moved into the CVI chamber (42).

After being subject to the treatment in the preheat chamber (41), the module (45) is moved into the CVI chamber (42). One module at a time is moved into the CVI chamber as illustrated in FIG. 3 or alternatively, various stacks of modules or configurations of stacks of modules can be moved into the CVI chamber. The modules can be moved continuously through the furnace or step-wise, as desired.

The preheat chamber (41) temperatures will transition from a safe loading temperature to approximately the CVI temperature as the module advances and the cool-down chamber (43) temperature will transition from the CVI chamber temperatures to a safe unloading temperature. The pre-heat chamber (41) and the cool-down chamber (43) are continuously purged of oxygen (air) or are purged before the modules are transferred from one chamber to the next. The transition temperature of the cool-down chamber (43) at the exit is preferably less than 482°C (900°F) and the module is removed. If a ceramic porous material is densified, then the transition temperature is preferably less than 815°C (1500 °F). Pre-heat chamber (41) is opened and reloaded. Both the pre-heat chamber (41) and the cool-down chamber (43) are again brought to the same environmental conditions in terms of pressure as the CVI chamber (42). The two chambers (41, 43) are also purged of oxygen (air) before the next transfer of modules in the furnace.

Alternatively, the temperature transition from the pre-heat and cool-down chambers can be a gradient. That is, the module is at the required temperature as it enters the CVI chamber and as it exits the CVI chamber, it does not drop the temperature of the CVI chamber below a temperature necessary or desired to operate the CVI chamber to achieve the desired density, so that a continuous movement of modules can be achieved. Preferably, the chamber shield would be a gas barrier, maintaining the CVI chamber free of oxygen and not impacting the CVI reaction in the CVI chamber. If a temperature gradient transition is used from the pre-heat to the cool-down chambers, the modules could be moved step-wise or continuously from zone to zone.

In the embodiment illustrated in FIG. 3, the CVI chamber (42) is sectioned off from the pre-heat chamber (41) and the cool-down chamber (43) by chamber shields (47). The chamber shields (47) insure that the temperature in the CVI chamber (42) are maintained. The chamber shields (47) can be of any material desired provided that the material can tolerate the high temperatures in the CVI chamber. Examples of suitable materials include graphite, ceramic, high temperature metals. In addition, the chamber shields (47) contain the reactant and effluent gas in the chamber as well as prevent the ingress and egress of atmospheric oxygen into the CVI chamber (42).

Similarly in this embodiment, reactant gas enters the CVI chamber (42) through a gas inlet (48), is preheated by a pre-heater (49) located in the CVI chamber (42), (if a pre-heater is needed or desired), and funneled to portion (50) of the CVI chamber in which the module (45) is positioned. Preferably, the pre-heater used is the one described in U.S.-A-5,480,678. Although the gas flow is shown from top to bottom of the CVI chamber in many of the embodiments described herein, it can be reversed if desired.

The reactant gas is directed from the pre-heater into the CVI chamber and thus improves the distribution of the reactant gas over the porous material. The pre-heater may include a baffle structure which comprises an array of rods, tubes, perforated plates or equivalent structure for dispersing the flow and increasing convective heat transfer from the baffle structure to the reactant gas.

One or more heater plates can be used in the furnace. In the particular embodiment shown in FIG. 3, two heater plates (51a, b) are used. One heater plate is positioned above and the other below the module (45) in the CVI chamber (42). For efficient heating, minimal clearance between the heater plates and modules is desired. Minimal clearance is enough clearance to allow variation in the height of successive modules and enough to tolerate a build-up of carbon deposits between the modules and the individual sheets of porous material within the modules themselves. In one embodiment, resistance heaters are used. Alternatively, induction heaters can be used.

The reactant gas flows through the heater plates (51a, 51b) and the stacks of porous materials (44) in the module (45). The reactant gas then leaves the CVI chamber (42) through a gas outlet (52). The module (45) is this embodiment is then moved to a cool-down chamber (43). In the cool-down chamber, the module is cooled. Preferably, the module is cooled to 482°C (900°F) or less. If the porous material is a ceramic, the densified material is cooled down to less than about 815°C (1500 °F) to prevent significant oxidation. The environmental conditions of the chambers are maintained as described above with respect to the movement of the modules from one chamber to the next.

A second pre-heater (not illustrated) may be used in the embodiment of FIG. 3. This second pre-heater can be located in the area below heater (51b) before the gas outlet (52). Placing a second pre-heater at this location enables the gas flow to be reversed, in accordance with the teachings of this application.

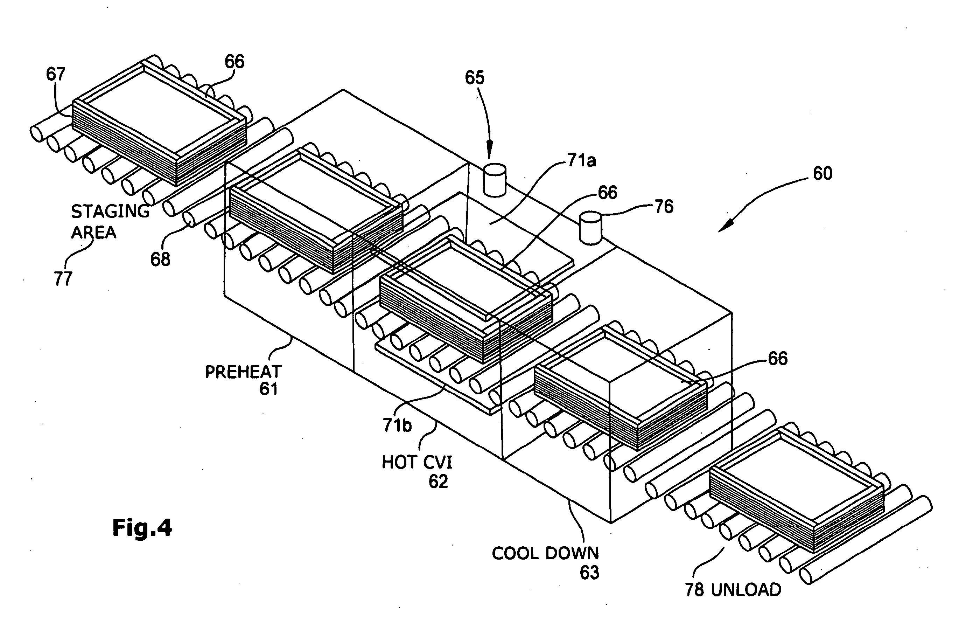

FIG. 4 schematically illustrates module (66) containing porous material (67) entering the furnace (60), going through the pre-heat chamber (61), the CVI chamber (62) and the cool-down chamber (63). This Figure shows that prior to entering the furnace, the module is set on the conveyor (68) in a staging area (77). At the end of the process, the modules (66) are unloaded in an unloading area (78) outside the furnace (60). The reactant gas enters the CVI chamber (62) via a gas inlet (65) and leaves the CVI chamber via a gas outlet (76). Alternatively, the reactant gas can be introduced in the preheat chamber (61) and exits the furnace through the cool-down chamber (63). Heater plates (71a, 71b) are included in the CVI chamber (62). The process conditions of this embodiment are the same as those of the embodiment of FIG. 1.

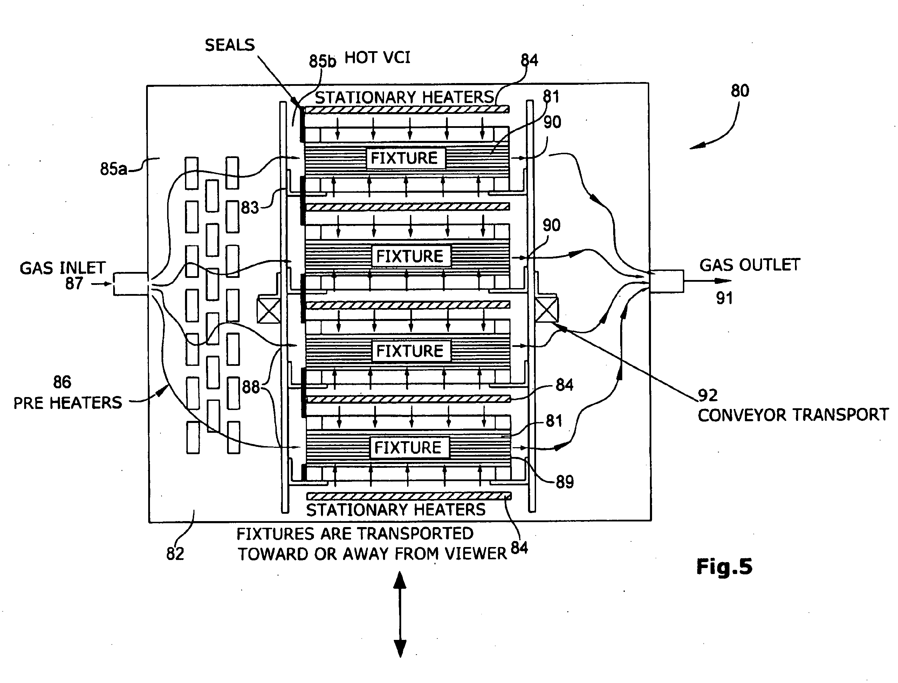

FIG. 5 illustrates yet another embodiment of the CVI furnace (80) of the invention. In this embodiment, modules (81) are stacked one upon each other before placement into the CVI chamber (82). In the particular figure, there are four modules stacked one upon the other. Any desired number of modules can be stacked as long as there is enough room to stack the modules in the CVI chamber (82). The modules are separated one from another on each end by spacers (83) so that when moved into the CVI chamber (82) there is enough room above and below each module (81) for a heater plate (84). The heater plate (84) is stationary. The spacers (83) need to be able to withstand the temperatures in the CVI chamber (82) and can be made of any material that can withstand such temperatures. Preferably, the spacers are formed from monolithic graphite or ceramic.

In this embodiment, the stacked modules (81) are moved into the CVI chamber (82). The CVI chamber in this embodiment is divided into two areas (85a, 85b). One area (85a) includes the gas pre-heater (86) (the preheater area) and the other area (85b) provides a sealed space for the stacked modules (81). The reactant gas enters the gas pre-heater (86) via a gas inlet (87), and is heated to the desired temperature, which is dependent upon the process conditions and the design of the pre-heater. The gas then flows through several exits (88) located in the pre-heater area (85a) into the second sealed area (85b) for the stacked modules (81). The exits (88) from the preheater area (85a) are aligned with the center of each module (81) in the stack when the modules are placed into the sealed area (85b). This ensures uniform reactant gas flow through the porous materials (89) stacked into the module (81) in and through the stacks of modules.

Above and below each module (81) in the sealed area (85b) of CVI chamber (82) is a heater plate (84). The heater plate ensures that the porous materials in the module are uniformly heated to achieve the desired results. The reactant gas flows through the modules (81) and out of the exits (90) provided in the sealed area (85b) for the stacked modules. The reactant gas then leaves CVI chamber (82) through a gas outlet (91). Upon completion of the densification of the porous materials, the stack of modules is then moved to a cool-down chamber via a conveyor (92).

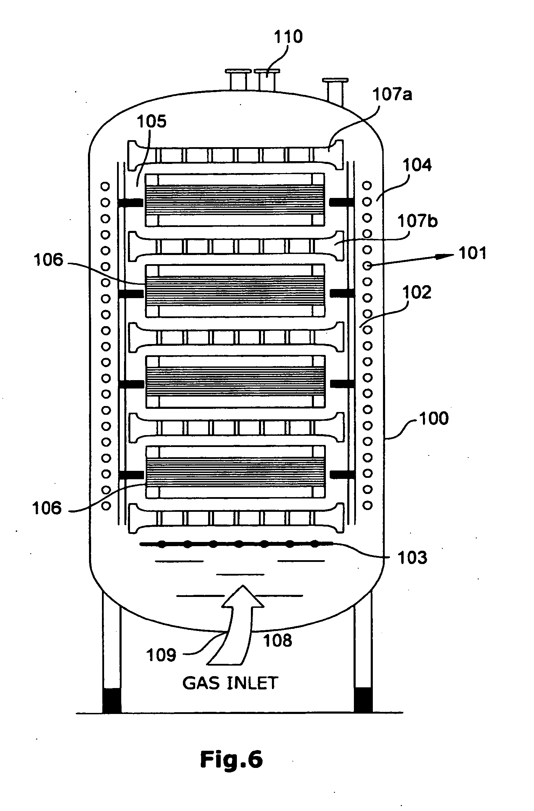

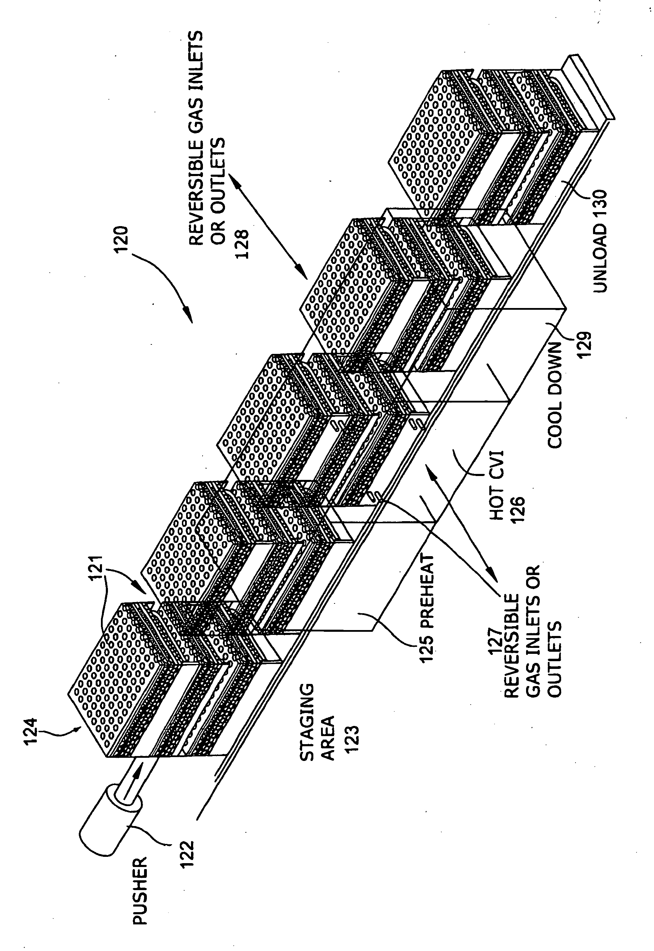

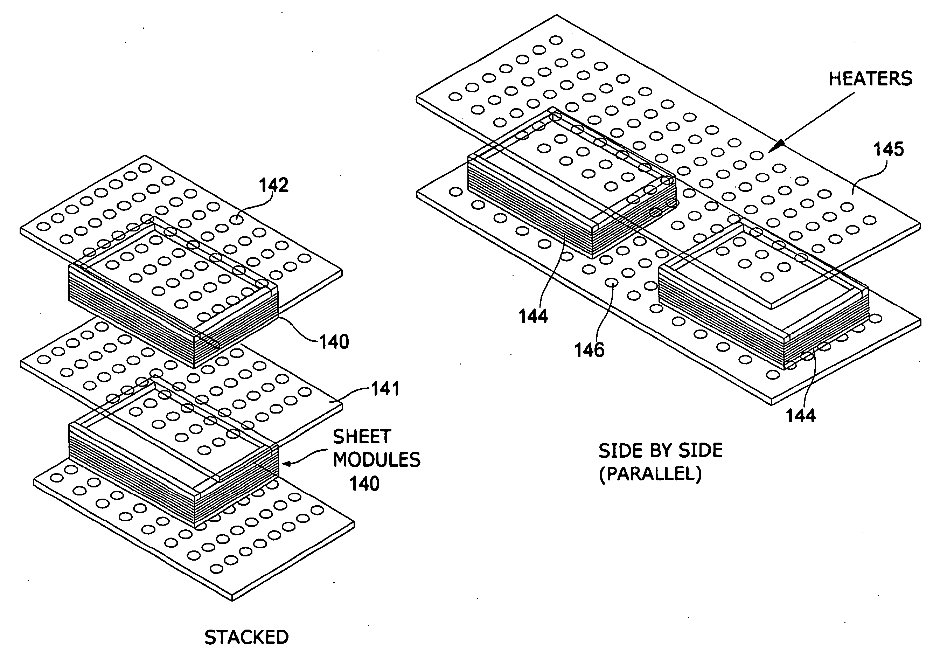

Yet another embodiment of the invention is described in FIG. 6. Here, a conventional CVI furnace (100) is converted to a furnace for use in this invention where porous material in modules to be densified. The process conditions described with respect to FIG. 2 are preferably used in this embodiment. However, these process conditions may be varied dependent upon the size of the porous material and the desired end result. This modified furnace can be used in a batch process. In this embodiment, the furnace includes an induction coil (101) disposed within the shell of the furnace. The susceptor preferably includes a susceptor wall (102) and a susceptor floor (103). The induction coil (101) is encased in a thermal and electrical insulating material. Additional thermal insulation (104) is placed between the coil and the susceptor.

Modules (106) with the porous material are stacked into this CVI chamber (105). Between each module are a top and bottom heating plate (107a, 107b), that are made from a high thermal conductivity material that will conduct heat from the wall of the susceptor (102) and across the face of the module to essentially uniformly heat the top and the bottom of the module (106). The thickness of the heating plates is sized to achieve the desired thermal balance in the CVI chamber to minimize temperature gradients across the module. The thickness of the heating plate near its outer periphery is larger than the center of the heating plate as shown in FIG. 6.

In this particular embodiment illustrated, the heater plates have holes in the plates to enable the reactant gas to flow around and through the heater plates (107a, 107b). Reactant gas is introduced into the bottom (108) of the furnace through a gas inlet (109). The reactant gas flows through the stacked modules (106) and heater plates (107a, 107b) out through the gas outlet (110). If desired, the modules can be designed to give flow across the surface of each stack of porous material, or alternatively, force the flow of the reactant has through each stack of porous material. With these configurations, a much more uniform distribution of the temperature and gas flow is achieved than in the conventional furnace.

FIG. 7 illustrates yet another representation of the furnace (120) of the instant invention, preferably using the same process conditions as the embodiment of FIG. 2. The process conditions used in this embodiment can be varied depending upon the size of the porous material and the desired end result. As shown in the FIG. 7, the modules (121) are moved through the chambers of the furnace using a pusher rod (122). Alternatively, any type of piston/ram structure, conveyor, roller of some low friction surface that will enable the modules to slide across can be used to move the modules through the chambers of the furnace provided that it can withstand the temperature in the furnace. The modules (121) are stacked in this embodiment in a staging area (123) before entering the furnace. The pusher rod (122) moves the stack (124) from the staging area (123) to the preheat area (125). In the preheat area (125), the stack (124) of modules is preheated to the desired temperature.

The pusher (122) then moves the next stack placed in the staging area, which in turn pushes the first stack (124) into the CVI chamber (126) as illustrated in FIG.7. The temperature transition from the pre-heater and the cool-down chambers from that of the CVI chamber can be a gradient such that the module is at the required temperature as it enters and exits the CVI chamber (126) and the temperature of the CVI chamber does not drop below a critical temperature, below which undesirable rate and structure may occur.

The CVI chamber (126) temperatures are maintained throughout the process. In this embodiment, several gas inlets (127) and several gas outlets (128) are provided for in the CVI chamber. These inlet (127) and outlets (128) are reversible. That is during the process, the gas flow can be reversed in this and other embodiments to help assure product uniformity of the deposited matrix, which may be determined by measurement on the porous material exiting the furnace. After densification of the porous materials in the stack of modules (124) in the CVI chamber (126) is complete, the stack (124) is moved into the cool-down chamber (129) to reach the pre-determined temperature by the next stack entering the CVI chamber as illustrated in the FIG. 7. Any type of cool-down chamber (129) can be used as desired. Once the cool-down predetermined temperature is reached, the stack (124) of modules is pushed out of the CVI furnace (120) to an unloading area (130) and the uniformly densified porous material sheets are unloaded.

FIGS. 8 and 9 show two alternate embodiments of possible stacking configurations for modules that could be used with the CVI furnace of this invention. Other configurations are possible provided that they can be placed in the CVI chamber. FIG. 8 shows modules (140) which are stacked one on top of each other. Also seen in this drawing are the heater plates (141) which are placed between the modules (140). In this embodiment, the heater plates (141) have holes (142) in the heater plates themselves to allow the reactant gas to flow through the heater plates in order to provide better uniformity.

Alternatively, the modules (144) can be placed side by side as shown in FIG. 9. Additional modules can be stacked on top of the two modules of FIG. 9, provided appropriate spacers are used. FIG. 9 also shows the heater plates (145) which are placed above and below each module. In this embodiment, the heater plates (145) are configured to extend the length of two modules. These heater plates (145) also have holes (146) to enable the reactant gas to flow through and around the heater plates. Alternate designs and embodiments of stacks, configurations and heater plates are possible and well within the scope of one of ordinary skill in the art.

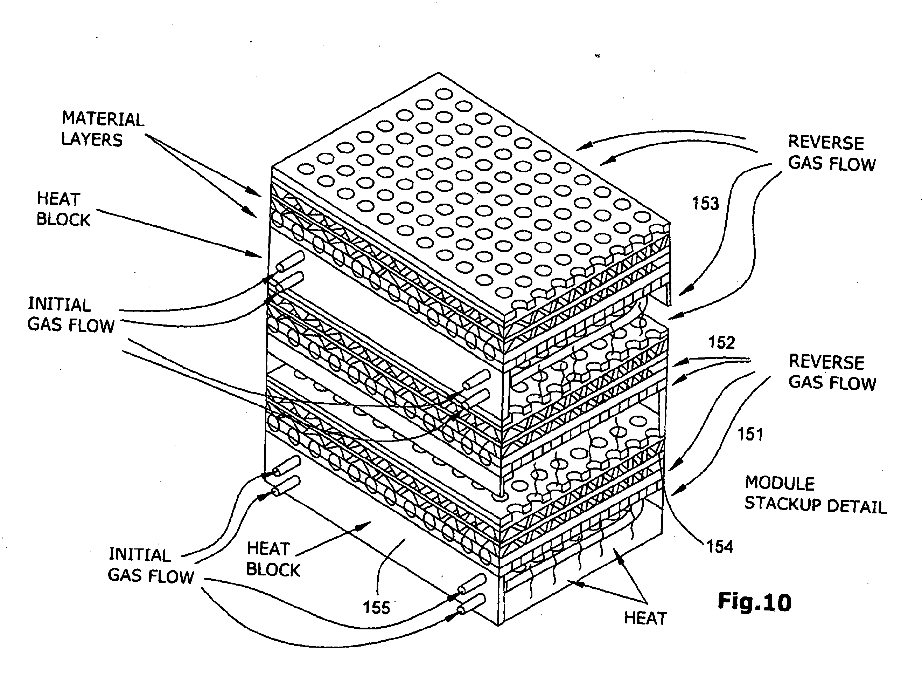

FIG. 10 shows a module stack (150) in detail which can be used in the furnaces of the embodiment of this invention disclosed herein. This stack contains three modules (151, 152, 153). Each module is configured to have top gas chamber, a bottom gas chamber and central area. A heat block (155) is provided between the modules. The heat block (155) must be made of a heat resistant material such as for example a graphite, ceramic, or a high temperature steel material. The heat block can be directly heated (resistively or inductively) or indirectly heated (radiation or convection). The porous material (154) which is to be densified is fitted into the central area of the module. In addition to the porous material, screens are placed above and below each piece of porous material in the central area. The porous materials and the screens are held in this central area of each module. Any type of means to hold such materials in place can be used, including slots, pins, and/or clips. Most preferably, the module has slots so that each layer of porous material and alternating screen layer can be fitted into the module. Alternate ways to fasten or hold the screens and porous materials can be used. The screens used in the module can be any type of screens. Preferably, the screens are made from a graphite material.

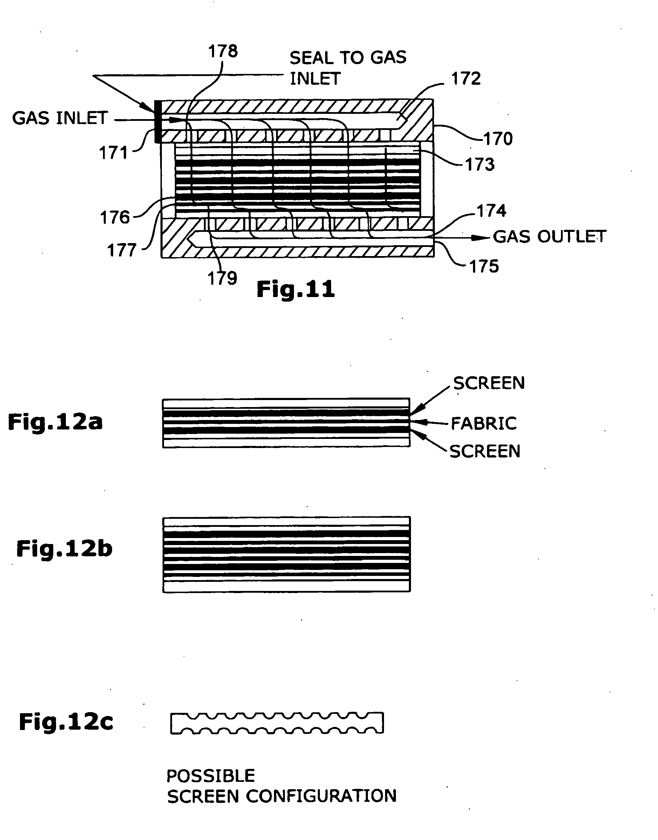

A module (170) which can be used in any of the CVI furnaces of the present invention is illustrated in FIG. 11. The design of this particular module provides for controlled gas flow through the multiple layers of porous material stacked in the module itself. In this embodiment, the module (170) is made of a block design and made of materials which can withstand the heat in the CVI chamber. For example, a graphite or ceramic material can be used to form the module.

The module has a sealed gas inlet (171), a top gas chamber (172), a central chamber (173) and a bottom gas chamber (174). The bottom gas chamber includes a gas outlet (175). Sheets of porous material (176) are stacked between screens (177) in the central chamber (173). Any type of means to hold such materials in place can be used, including slots, pins and/or clips. Most preferably, the module has slots so that each layer of porous material and alternating screen layer can be fitted into the module. The screens used in the module can be any type of screens. Preferably, the screens are made from a graphite material. The screens provide structural support for the porous material. In this embodiment, the screens also allow gas flow through the screen and porous material.

The central chamber (173) has inlets (178) from the top gas chamber (172) and outlets (179) into the bottom gas chamber (174). The reactant gas flows into the module itself from an inlet or several inlets in the CVI chamber which correspond to the inlets in the module, and through the bottom gas chamber. The gas passes through the layers of screen and porous material. Finally, the gas exits the central area through slots in the bottom of the central area and flows into the bottom gas chamber. From the bottom gas chamber, the reactant gas flows out of the module through a gas outlet (175).

In this embodiment, the gas inlet and gas outlet in the modules are reversible. That is, the flow of gas can be reversed to help ensure that all the areas of the porous material receive a uniform amount of reactant gas and thus become uniformly densified. This reversal of the gas flow can occur at any time desired or multiple times during the processing.

FIG. 12a, 12b, 12c illustrate the possible configurations for the screens and porous materials to be inserted into the module. In addition, this Figure shows a possible screen configuration which promotes more uniform gas flow around and through the porous material to be densified during the CVI process. As can be seen in FIGS. 12a and 12b, the screens can have holes to accommodate gas flow through the fabric. However, the screens can possibly be configured as in FIG. 12c with only grooves, enabling the gas to flow across the fabric as opposed to through the fabric

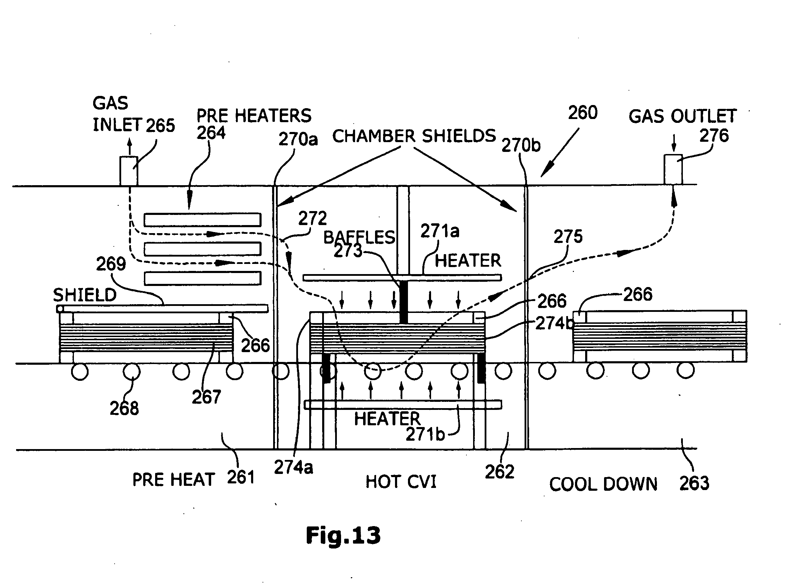

FIG. 13 illustrates yet another embodiment of the furnace (260) of the instant invention. In this embodiment, the furnace is also divided into three chambers, a preheat chamber (261), a CVI chamber (262) and a cool-down chamber (263). In this embodiment, the reactant gas is preheated in a pre-heater (264) which is located in the preheat chamber (261). Consequently, the reactant gas is introduced into the furnace (260) by gas inlet (265) located in the preheat chamber (261)

A module (266) carrying the sheets of porous materials (267) stacked into a module is introduced into the preheat chamber (261). As illustrated in FIG. 13, a conveyor (268) is used to introduce the module into the preheat chamber, although any other means to convey the module into the chamber can be used. Alternatively, any type of piston/ram structure, conveyor, roller of some low friction surface that will enable the modules to slide across can be used to move the modules through the chambers of the CVI furnace provided that it can withstand the temperature in the furnace.

A shield (269) is located between the module (266) and the pre-heater (264) in the preheat chamber (261) in order to keep the reactant gases away from the porous material (267) in the module (266).

The module (266) is then moved into the CVI chamber (262) as shown in FIG. 13. Chamber shields (270a, 270b) separate the preheat chamber (261) and the cool-down chamber (263) from the CVI chamber (262). A plate heater (271 a, 271b) is positioned both above and below the module (266) in the CVI chamber (262), which is maintained at a uniform temperature.

The reactant gas is introduced from the pre-heater (264) to the CVI chamber (262) through an entrance (272) in the chamber shield (270a). Baffles (273) direct the reactant gas down to the first half of the porous material (274a) in the module (266) in the CVI chamber (262). The reactant gas is then deposited on a first portion of the porous material (274a). The reactant gas then is further directed up through the CVI chamber (262) and through the second half of the porous material (274b) in the module. The reactant gas then flows from the CVI chamber (262) through an exit (275) in the chamber shield (270b) into the cool-down chamber (263). The reactant gas is cooled and then removed from the cool-down chamber (263) by gas outlet (276).

Alternatively, the reactant gas can be removed from the CVI chamber (not shown) and circulated through a heat exchanger which can be used to help preheat the gas introduced into gas inlet (265).

The module (266) is then moved from the CVI chamber (262) of FIG. 13, to the cool-down chamber (263). After the sheets of porous material (267) in the modules (266) are cooled appropriately, they are unloaded and removed from the modules (266).

The process described herein can be used to form a high temperature structural composite by the deposition of a ceramic or carbonaceous material matrix within a carbonaceous or ceramic porous material. Consequently, the equipment used in such process may differ depending upon the type of matrix material used as well as the type of porous material which the matrix is being deposited on.

This invention also includes the process of densifying sheets or preforms of porous material during a CVI process. In particular, the invention includes the step of introducing the porous material loaded in modules as specified in Fig.11 into a CVI chamber which is maintained at desired temperatures, passing reactant gas around the porous material so that it is densified and removing the densified material from CVI chamber. Product properties using the conditions set forth herein in accordance with the invention are comparable to those product properties obtained by conventional processes.

The porous sheets subjected to the treatment in the furnace of the instant invention form composites which can have many different applications. For example, if the composite is a carbon-carbon composite, it can be used for wet friction applications in the automotive industry. Also, it may be possible to use the composite for disks in aircraft brakes, rocket parts such as nose cones, fuel injectors, thrust chambers or exit nozzles, wing leading edge caps. It is believed that these composites will be able to be used in circuit boards and other uses which require a strong yet lightweight material which is able to withstand high temperatures.

## Claims

1. A module for processing porous material in a CVI furnace, comprising a block having a top gas chamber (172) with gas inlet and several gas outlets, a middle chamber (173) having gas inlets and gas outlets, wherein said gas inlets connect to said top gas chamber outlets, and a bottom gas chamber (174) having gas inlets and a gas outlet, wherein said gas inlets connect to said middle chamber gas outlets.

2. The module according to claim 1, wherein the block is a graphite block.

3. The module according to claim 1, wherein the block is a ceramic block.

4. The module according to any one of claims 1to 3, wherein porous material(33;44;67;89;154;176;267) is placed into said middle chamber (173) of said module (34;45;66;81;106;121;140;144;151,152,153;170; 266).

5. The module according to any one of claims 1 to 4, wherein a screen (177) is placed above said porous material (33;44;67;89;154;176;267).

6. The module according to any one of claims 1 to 5, wherein a screen (177) is placed below said porous material (33;44;67;89;154;176;267).

7. A process for processing porous material (33;44; 67; 89;154;176; 267) in a CVI furnace having a CVI chamber (31;42;62;82;105;126;262) which is maintained at desired process conditions, comprising
- providing a module comprising a block having a top gas chamber (172) with gas inlet and several gas outlets, a middle chamber (173) having gas inlets and gas outlets, wherein said gas inlets connect to said top gas chamber outlets, and a bottom gas chamber (174) having gas inlets and a gas outlet, wherein said gas inlets connect to said middle chamber gas outlets,
- placing porous material (33;44;67;89;154;176;267) into said module (34;45;66;81;106;121;140;144;151,152,153;170:266),
- loading said module (34;45;66;81;106;121;140:144;151,152,153; 170;266) into said CVI chamber (31;42;62;82;105;126;262),and
- introducing a reactant gas into said CVI chamber (31;42;62;82;105;126;262) while heating said porous material (33;44;f7;89;x54;1,76;257) In said module (34;45;66;81;106;121;140;144;151,152,153;170;266) with a heater plate (36a,b;51a,b;71a,b;84,107a, b;145;271a,b) located proximate said porous material (33;44;67;89;154;176;267),
- whereby said porous material (33;44;67;89;154;176;267) in said module (34;45;66;81;106;121;140;144;151,152,153;170;266) is densified.

8. The process according to claim 7, wherein said heater plate(36a,b; 51a,b;71a,b;84,107a, b;145;271a,b) is located above said module (34;45;66;81;106;121;140;144:151,152,153;170;266).

9. The process according to any one of claims 7 or 8, wherein said heater plate(36a,b;51a,b;71a,b;84,107a, b;145;271a,b) is located below said module (34;45;66;81;106;121;140;144;151,152,153;170;266).

10. The process according to claim 8, wherein said CVI chamber (31;42;62; 82:105;126;262) includes an additional heater plate (36a,b;51a,b;71a,b; 84,107a, b;145;271a,b) located below said module (34;45;66;81;106; 121; 140;144;151,152,153;170;266).

11. The process according to any one of claims 1 to 10, wherein said gas flow is reversed during said process.

12. The process according to any one of claims 7 to 11, wherein the heater plate (36a,b;51a,b;71a,b;84,107a, b;145;271a,b) has a first thickness at its center and a second thickness at its periphery whereby the second thickness is larger than the first thickness.

13. The process according to any one of claims 1 to 12, wherein porous material (33;44;67;89;154;176;267) is placed into said middle chamber (173) of said module (34;45;66;81;106;121;140;144;151,152,153;170; 266).

14. The process according to any one of claims 1 to 13, wherein a screen (177) is placed above said porous material (33;44;67;89;154;176;267).

15. The process according to any one of claims 1 to 14, wherein a screen (177) is placed below said porous material (33;44;67;89;154;176;267).

16. The process according to any one of claims 7 to 15, wherein said porous material (33;44;67;89;154;176;267) is removed from the CVI chamber (31;42;62;82;105;126;262) and cooled down.

17. The process according to any one of claims 7 to 16, wherein said gas flow is reversed during said process.

18. The process according to any one of claims 7 to 17, wherein said reactant gas comprises natural gas.

19. The process according to claim 18, wherein ethane and propane is added to the natural gas.

20. The process according to any one of claims 7 to 17, wherein said reactant gas comprises a mixture of methane and propane.

21. The process according to claim 20, wherein said mixture comprises about 92.5% methane and about 7.5% propane.

22. The process according to any one of claims 1 to 21, wherein the porous material (33;44;67;89;154;176;267) comprises multiple layers of porous material (33;44;67;89;154;176;267).

23. The process according to claim 22, wherein said layers of porous material (33;44;67;89;154;176;267) are stacked into a module (34;45;66;81; 106;121;140;144;151,152,153;170;266).

24. The process according to any one of claims 7 to 23, wherein the step of providing a module (34;45;66;81;106;121;140;144;151,152,153;170; 266) comprises providing a module (34;45;66;81;106;121;140;144;151, 152,153;170;266) having a graphite block.

25. The process according to any one of claims 7 to 23, wherein the step of providing a module (34;45;66;81;106;121;140;144;151,152,153;170; 266) comprises providing a module (34;45; 66;81;106;121;140;144;151, 152,153; 170; 266) having a ceramic block.

## Patentansprüche

1. Modul zum Verarbeiten porösen Materials in einem CVI-Ofen, mit einem Block, der eine obere Gaskammer (172) mit einem Gaseinlass und mehreren Gasauslässen, eine mittlere Kammer (173) mit mit den Auslässen der oberen Gaskammer verbundenen Gaseinlässen und Gasauslässen, und eine untere Gaskammer (174) mit Gaseinlässen und einem Gasauslass aufweist, wobei die Gaseinlässe mit den Gasauslässen der mitteren Gaskammer verbunden sind.

2. Modul nach Anspruch 1, bei dem der Block ein Graphitblock ist.

3. Modul nach Anspruch 1, bei dem der Block ein Keramikblock ist.

4. Modul nach einem der Ansprüche 1 bis 3, bei dem poröses Material (33;44;67;89;154;176;267) in der mittleren Kammer (173) des Moduls (34;45;66;81;106;121;140;144;151,152,153;170;266) platziert ist.

5. Modul nach einem der Ansprüche 1 bis 4, bei dem ein Gitter (177) über dem porösen Material (33;44;67;89;154;176;267) platziert ist.

6. Modul nach einem der Ansprüche 1 bis 5, bei dem ein Gitter (177) unter dem porösen Material (33;44;67;89;154;176;267) platziert ist.

7. Verfahren zum Verarbeiten porösen Materials (33;44;67;89;154;176; 267) in einem CVI-Ofen mit einer CVI-Kammer (31;42;62;82;105; 126;262), die auf den gewünschten Prozessbedingungen gehalten wird, mit folgenden Schritten:
- Bereitstellen eines Moduls mit einem Block, der eine obere Gaskammer (172) mit einem Gaseinlass und mehreren Gasauslässen, eine mittlere Kammer (173) mit Gaseinlässen und mit mit den Auslässen der oberen Gaskammer verbundenen Gasauslässen, und eine untere Gaskammer (174) mit Gaseinlässen und einem Gasauslass aufweist, wobei die Gaseinlässe mit den Gasauslässen der mitteren Gaskammer verbunden sind,
- Platzieren eines porösen Materials (33;44;67;89;154;176;267) in dem Modul (34;45;66;81;106;121;140;144;151,152,153;170;266),
- Laden des Moduls (34;45;66;81;106;121;140;144;151,152,153; 170;266) in die CVI-Kammer (31;42;62;82;105;126;262), und
- Einlassen eines Reaktantengases in die CVI-Kammer (31;42;62;82; 105;126;262), während das poröse Material (33;44;67;89;154;176; 267) in dem Modul (34;45;66;81;106;121;140;144;151,152,153; 170;266) mittels einer nahe dem porösen Material (33;44;67;89; 154;176;267) angeordneten Heizplatte (36a,b;51a,b;71a,b;84, 107a,b;145;271a,b) geheizt wird,
- wodurch das in dem Modul (34;45;66;81;106;121;140;144;151, 152,153;170;266) befindliche poröse Material (33;44;67;89;154; 176;267) verdichtet wird.

8. Verfahren nach Anspruch 7, bei dem die Heizplatte (36a,b;51a,b; 71a,b;84,107a,b;145;271a,b) über dem Modul (34;45;66;81;106; 121;140;144;151,152,153;170; 266) angeordnet ist.

9. Verfahren nach Anspruch 7 oder 8, bei dem die Heizplatte (36a,b; 51a,b;71a,b;84,107a,b;145;271a,b) unter dem Modul (34;45;66;81; 106;121;140;144;151,152,153;170;266) angeordnet ist.

10. Verfahren nach Anspruch 8, bei dem die CVI-Kammer (31;42;62;82; 105;126;262) eine zusätzliche Heizplatte (36a,b;51a,b;71a,b;84, 107a,b;145;271a,b) aufweist, die unter dem Modul (34;45;66;81; 106;121;140;144;151,152,153;170;266) angeordnet ist.

11. Verfahren nach einem der Ansprüche 1 bis 10, bei dem der Gasstrom während des Verfahrens umgekehrt wird.

12. Verfahren nach einem der Ansprüche 7 bis 11, bei dem die Heizplatte (36a,b;51a,b;71a,b;84,107a,b;145;271a,b) eine erste Dicke in ihrer Mitte und eine zweite Dicke an ihrem Randbereich hat, wobei die zweite Dicke größer als die erste Dicke ist.

13. Verfahren nach einem der Ansprüche 1 bis 12, bei dem poröses Material (33;44;67;89;154;176;267) in der mittleren Kammer (173) des Moduls (34;45;66;81;106;121;140;144;151,152,153;170;266) platziert wird.

14. Verfahren nach einem der Ansprüche 1 bis 13, bei dem ein Gitter (177) über dem porösen Material (33;44;67;89;154;176;267) platziert wird.

15. Verfahren nach einem der Ansprüche 1 bis 14, bei dem ein Gitter (177) unter dem porösen Material (33;44;67;89;154;176;267) platziert wird.

16. Verfahren nach einem der Ansprüche 7 bis 14, bei dem das poröse Material (33;44;67;89;154;176;267) aus der CVI-Kammer (31;42;62;82; 105;126;262) herausgenommen und gekühlt wird.

17. Verfahren nach einem der Ansprüche 7 bis 16, bei dem der Gasstrom während des Verfahrens umgekehrt wird.

18. Verfahren nach einem der Ansprüche 7 bis 17, bei dem das Reaktant Erdgas aufweist.

19. Verfahren nach Anspruch 18, bei dem dem Erdgas Ethan und Propan zugegeben werden.

20. Verfahren nach einem der Ansprüche 7 bis 17, bei dem das Reaktant eine Mischung aus Methan und Propan aufweist.

21. Verfahren nach Anspruch 20, bei dem die Mischung ungefähr 92,5 % Methan und ungefähr 7,5% Propan aufweist.

22. Verfahren nach einem der Ansprüche 1 bis 21, bei dem das poröse Material (33;44;67;89;154;176;267) mehrere Schichten porösen Materials (33;44;67;89;154;176;267) aufweist.

23. Verfahren nach Anspruch 22, bei dem die Schichten porösen Materials (33;44;67;89;154;176;267) in einem Modul (34;45;66;81;106;121; 140;144;151,152,153;170;266) gestapelt sind.

24. Verfahren nach einem der Ansprüche 7 bis 23, bei dem der Schritt des Bereitstellen eines Moduls (34;45;66;81;106;121;140;144;151,152, 153;170;266) das Bereitstellen eines Moduls (34;45;66;81;106;121; 140;144;151,152,153; 170;266) mit einem Graphitblock umfasst.

25. Verfahren nach einem der Ansprüche 7 bis 23, bei dem der Schritt des Bereitstellen eines Moduls (34;45;66;81;106;121;140;144;151,152, 153;170;266) das Bereitstellen eines Moduls (34;45;66;81;106;121; 140;144;151,152,153; 170;266) mit einem Keramikblock umfasst.

## Revendications

1. Module de traitement d'un matériau poreux dans un four d'infiltration en phase vapeur CVI, comprenant un bloc comportant une chambre à gaz supérieure (172) équipée d'une admission de gaz et de plusieurs sorties de gaz, une chambre médiane (173) équipée d'admissions de gaz et de sorties de gaz, lesdites admissions de gaz se raccordant aux sorties de ladite chambre à gaz supérieure, et une chambre à gaz inférieure (174) équipée d'admissions de gaz et d'une sortie de gaz, lesdites admissions de gaz se raccordant aux sorties de gaz de ladite chambre médiane.

2. Module selon la revendication 1, dans lequel le bloc est un bloc de graphite.

3. Module selon la revendication 1, dans lequel le bloc est un bloc en céramique.

4. Module selon l'une quelconque des revendications 1 à 3, dans lequel du matériau poreux (33 ; 44 ; 67 ; 89 ; 154 ; 176 ; 267) est placé dans ladite chambre médiane (173) dudit module (34 ; 45 ; 66 ; 81 ; 106 ; 121 ; 140 ; 144; 151, 152, 153 ; 170 ; 266).

5. Module selon l'une quelconque des revendications 1 à 4, dans lequel un tamis (177) est placé au-dessus dudit matériau poreux (33 ; 44 ; 67 ; 89 ; 154 ; 176 ; 267).

6. Module selon l'une quelconque des revendications 1 à 5, dans lequel un tamis (177) est placé au-dessous dudit matériau poreux (33 ; 44 ; 67; 89; 154; 176; 267).

7. Procédé de traitement du matériau poreux (33 ; 44 ; 67 ; 89 ; 154 ; 176 ; 267) dans un four d'infiltration en phase vapeur CVI, comprenant une chambre d'infiltration en phase vapeur CVI (31 ; 42 ; 62 ; 82 ; 105 ; 126 ; 262) qui est maintenue dans les conditions de traitement désirées, comprenant les étapes suivantes :
- fournir un module comprenant un bloc comportant une chambre à gaz supérieure (172) équipée d'une admission de gaz et de plusieurs sorties de gaz, une chambre médiane (173) équipée d'admissions de gaz et de sorties de gaz, lesdites admissions de gaz se raccordant aux sorties de ladite chambre à gaz supérieure, et une chambre à gaz inférieure (174) équipée d'admissions de gaz et d'une sortie de gaz, lesdites admissions de gaz se raccordant aux sorties de gaz de ladite chambre médiane,
- placer du matériau poreux (33 ; 44 ; 67 ; 89 ; 154 ; 176 ; 267) dans ledit module (34 ; 45 ; 66 ; 81 ; 106 ; 121 ; 140 ; 144 ; 151, 152, 153 ; 170 ; 266),
- charger ledit module (34 ; 45 ; 66 ; 81 ; 106 ; 121 ; 140 ; 144 ; 151, 152, 153 ; 170 ; 266) dans ladite chambre d'infiltration en phase vapeur CVI (31 ; 42 ; 62 ; 82 ; 105 ; 126 ; 262), et
- introduire un gaz réactif dans ladite chambre d'infiltration en phase vapeur CVI (31 ; 42 ; 62 ; 82 ; 105 ; 126 ; 262) tout en chauffant ledit matériau poreux (33 ; 44 ; 67 ; 89 ; 154 ; 176 ; 267) dans ledit module (34 ; 45 ; 66 ; 81 ; 106 ; 121 ; 140 ; 144 ; 151, 152, 153 ; 170 ; 266) au moyen d'une plaque chauffante (36a,b ; 51a,b ; 71a,b ; 84, 107a,b ; 145 ; 271a,b) située à proximité dudit matériau poreux (33 ; 44 ; 67 ; 89 ; 154 ; 176 ; 267),
- ledit matériau poreux (33 ; 44 ; 67 ; 89 ; 154 ; 176 ; 267) dans ledit module (34 ; 45 ; 66 ; 81 ; 106 ; 121 ; 140 ; 144 ; 151, 152, 153 ; 170 ; 266) étant ainsi densifié.

8. Procédé selon la revendication 7, dans lequel ladite plaque chauffante (36a,b ; 51a,b ; 71a,b ; 84, 107a,b ; 145 ; 271a,b) est située au-dessus dudit module (34 ; 45 ; 66 ; 81 ; 106 ; 121 ; 140 ; 144 ; 151, 152, 153 ; 170 ; 266).

9. Procédé selon l'une quelconque des revendications 7 ou 8, dans lequel ladite plaque chauffante (36a,b ; 51a,b ; 71a,b ; 84, 107a,b ; 145 ; 271a,b) est située au-dessous dudit module (34 ; 45 ; 66 ; 81 ; 106 ; 121 ; 140 ; 144 ; 151, 152, 153 ; 170 ; 266).

10. Procédé selon la revendication 8, dans lequel ladite chambre d'infiltration en phase vapeur CVI (31 ; 42 ; 62 ; 82 ; 105 ; 126 ; 262) comprend une plaque chauffante supplémentaire (36a,b ; 51a,b ; 71 a,b ; 84, 107a,b ; 145 ; 271a,b) située au-dessous dudit module (34 ; 45 ; 66 ; 81 ; 106 ; 121 ; 140 ; 144 ; 151, 152, 153 ; 170 ; 266).

11. Procédé selon l'une quelconque des revendications 1 à 10, dans lequel l'écoulement dudit gaz est inversé pendant ledit processus.

12. Procédé selon l'une quelconque des revendications 7 à 11, dans lequel la plaque chauffante 36a,b ; 51a,b ; 71 a,b ; 84, 107a,b ; 145 ; 271a,b) présente un première épaisseur en son centre et une seconde épaisseur sur sa périphérie, la seconde épaisseur étant ainsi plus grande que la première épaisseur.

13. Procédé selon l'une quelconque des revendications 1 à 12, dans lequel le matériau poreux (33 ; 44 ; 67 ; 89 ; 154 ; 176 ; 267) est placé dans ladite chambre médiane (173) dudit module (34 ; 45 ; 66 ; 81 ; 106 ; 121 ; 140 ; 144 ; 151, 152, 153 ; 170 ; 266).

14. Procédé selon l'une quelconque des revendications 1 à 13, dans lequel un tamis (177) est placé au-dessus dudit matériau poreux (33 ; 44 ; 67 ; 89 ; 154 ; 176 ; 267).

15. Procédé selon l'une quelconque des revendications 1 à 14, dans lequel un tamis (177) est placé au-dessous dudit matériau poreux (33 ; 44 ; 67 ; 89 ; 154 ; 176 ; 267).

16. Procédé selon l'une quelconque des revendications 7 à 15, dans lequel ledit matériau poreux (33 ; 44 ; 67 ; 89 ; 154 ; 176 ; 267) est retiré de la chambre d'infiltration en phase vapeur CVI (31 ; 42 ; 62 ; 82 ; 105 ; 126 ; 262) et refroidi.

17. Procédé selon l'une quelconque des revendications 7 à 16, dans lequel ledit écoulement de gaz est inversé pendant ledit processus.

18. Procédé selon l'une quelconque des revendications 7 à 17, dans lequel ledit gaz réactif comprend du gaz naturel.

19. Procédé selon la revendication 18, dans lequel de l'éthane et du propane sont ajoutés au gaz naturel.

20. Procédé selon l'une quelconque des revendications 7 à 17, dans lequel ledit gaz réactif comprend un mélange de méthane et de propane.

21. Procédé selon la revendication 20, dans lequel ledit mélange comprend environ 92,5 % de méthane et environ 7,5 % de propane.

22. Procédé selon l'une quelconque des revendications 1 à 21, dans lequel le matériau poreux (33 ; 44; 67 ; 89 ; 154 ; 176 ; 267) comprend des couches multiples de matériau poreux (33 ; 44 ; 67 ; 89 ; 154 ; 176 ; 267).

23. Procédé selon la revendication 22, dans lequel lesdites couches de matériau poreux (33 ; 44 ; 67 ; 89 ; 154 ; 176; 267) sont empilées pour former un module (34 ; 45 ; 66 ; 81 ; 106 ; 121 ; 140 ; 144 ; 151, 152, 153 ; 170 ; 266).

24. Procédé selon l'une quelconque des revendications 7 à 23, dans lequel l'étape consistant à fournir un module (34 ; 45 ; 66 ; 81 ; 106 ; 121 ; 140 ; 144 ; 151, 152, 153 ; 170 ; 266) consiste à fournir un module (34 ; 45 ; 66 ; 81 ; 106 ; 121 ; 140 ; 144; 151, 152, 153 ; 170 ; 266) comportant un bloc de graphite.

25. Procédé selon l'une quelconque des revendications 7 à 23, dans lequel l'étape consistant à fournir un module (34 ; 45 ; 66 ; 81 ; 106 ; 121 ; 140 ; 144 ; 151, 152, 153 ; 170 ; 266) consiste à fournir un module (34 ; 45 ; 66 ; 81 ; 106 ; 121 ; 140 ; 144 ; 151, 152, 153 ; 170 ; 266) comportant un bloc de céramique.
